# EUROPÄISCHE PATENTSCHRIFT

(11) **EP 1 597 760 B1**
(45) Veröffentlichungstag und Bekanntmachung des Hinweises auf die Patenterteilung: **15.12.2010**
(21) Anmeldenummer: 04709236.6
(22) Anmeldetag: 09.02.2004
(51) Int. Cl.: H01L 21/768

(54) **INTEGRIERTES ELEKTRONISCHES BAUELEMENT MIT GEZIELT ERZEUGTEN NANORÖHREN IN VERTIKALEN STRUKTUREN**
INTEGRATED ELECTRONIC COMPONENT HAVING SPECIFICALLY PRODUCED NANOTUBES IN VERTICAL STRUCTURES
COMPOSANT ELECTRONIQUE INTEGRE COMPORTANT DES NANOTUBES PRODUITS DE FACON CIBLEE DANS DES STRUCTURES VERTICALES

(30) Priorität: 24.02.2003 DE 10307815
(43) Veröffentlichungstag der Anmeldung: 23.11.2005
(73) Patentinhaber: Infineon Technologies AG, 85579 Neubiberg (DE)
(72) Erfinder: SEIDEL, Robert, 81539 München (DE); KREUPL, Franz, 80802 München (DE); GRAHAM, Andrew, 81547 München (DE)
(74) Vertreter: Müller-Boré & Partner Patentanwälte
(86) Internationale Anmeldenummer: PCT/EP2004/001158
(87) Internationale Veröffentlichungsnummer: WO 2004/075288

(56) Entgegenhaltungen:
- WO-A-01/61753
- DELZEIT L ET AL: "Growth of multiwall carbon nanotubes in an inductively coupled plasma reactor" J. APPL. PHYS. (USA), JOURNAL OF APPLIED PHYSICS, 1 MAY 2002, AIP, USA, Bd. 91, Nr. 9, 1. Mai 2002 (2002-05-01), Seiten 6027-6033, XP002286792 ISSN: 0021-8979
- DELZEIT L ET AL: "Growth of carbon nanotubes by thermal and plasma chemical vapour deposition processes and applications in microscopy" NANOTECHNOLOGY (UK), NANOTECHNOLOGY, JUNE 2002, IOP PUBLISHING, UK, Bd. 13, Nr. 3, Juni 2002 (2002-06), Seiten 280-284, XP002286793 ISSN: 0957-4484

## Beschreibung

Die vorliegende Erfindung betrifft ein integriertes elektronisches Bauelement, umfassend ein Substrat, mindestens ein Metall-Mehrschichtsystem, das mindestens bereichsweise auf dem Substrat angeordnet ist, und eine auf dem Metall-Mehrschichtsystem angeordnete, nicht-leitende Schicht, die mindestens ein Kontaktloch aufweist, worin mindestens eine Nanoröhre am Boden des Kontaktlochs an dem Metall-Mehrschichtsystem aufgewachen ist, wobei das Metall-Mehrschichtsystem aus einer hochschmelzenden Metallschicht, einer Metalltrennschicht und einer Katalysatorschicht aufgebaut ist. Ferner betrifft die vorliegende Erfindung ein Verfahren zur gezielten Erzeugung von Nanoröhren in vertikalen Strukturen.

Es ist üblich, in einem elektronischen Bauelement, welches in integrierter Bauweise ausgestaltet ist, zwei leitende Schichten, die durch eine nicht-leitende Schicht elektrisch isoliert sind, miteinander elektrisch leitend zu verbinden, indem durch die nicht-leitende Schicht ein Kontaktloch geätzt wird. Das Kontaktloch wird mit Metall aufgefüllt, wodurch eine metallische Durchkontaktierung erzeugt wird, welche die beiden leitenden Schichten miteinander elektrisch leitend verbindet.

Ein Nachteil dieser Vorgehensweise ist darin zu sehen, daß insbesondere bei abnehmenden lateralen Abmessungen, d.h. bei abnehmendem Durchmesser eines Kontaktlochs durch die nicht-leitende Schicht und bei zunehmender vertikaler Ausdehnung bzw. zumindest bei zunehmendem Aspektverhältnis, das vollständige Auffüllen des Kontaktlochs mit Metall problematisch und fehlerbehaftet ist. Insbesondere kommt es häufig zu einer Verstopfung im oberen Bereich des Kontaktlochs durch das abgeschiedene Metall, wodurch verhindert wird, daß das gesamte Kontaktloch mit Metall gefüllt wird. Somit kann häufig keine elektrisch leitende Verbindung zwischen den beiden leitenden Schichten erzeugt werden. Zudem führt ein unvollständig gefülltes Kontaktloch zu Zuverlässigkeitsproblemen.

Ein weiterer Nachteil der bekannten Vorgehensweise ist darin zu sehen, daß bei einem Kontaktloch mit einem sehr geringen Aspektverhältnis die Leitfähigkeit der metallischen Durchkontaktierung stark abnimmt, d.h. die metallische Durchkontaktierung stellt ein in erheblicher Weise begrenzendes Element für die Skalierung eines Metallisierungssystems und damit einer integrierten Schaltung dar, bei denen es erforderlich ist, in vertikaler Richtung eines elektronischen Bauelements mehrere leitende Schichten miteinander durch nicht-leitende Schichten hindurch elektrisch leitend zu verbinden.

Infolge der Eignung von Nanoröhren, insbesondere Kohlenstoffnanoröhren, als metallische Leiter sowie als Halbleiter ist es im Rahmen der Nanotechnik wünschenswert, solche Nanoröhren in elektronischen Bauteilen zu integrieren.

So ist beispielsweise aus Jung Sang Suh und Jin Seung Lee, Highly Ordered Two-Dimensional Carbon Nanotubes Areas, Applied Physics Letters, Vol. 75, Nr. 14, S. 2047-1049, Oktober 1999, ein Verfahren bekannt, Kohlenstoffnanoröhren in einer perforierten Al₂O₃-Matrix selbstjustiert aufzuwachsen.

Bisher wurden Nanoröhren nur mittels einer einzigen Katalysatorschicht auf der Oberfläche von Metallkontakten angeordnet(DE 100 06 964 C2). Die Katalysator- und Metallschichten werden dabei normalerweise mittels physikalischer Abscheidung (z.B. Sputtern) auf ein mit Lack strukturiertes flaches Substrat aufgebracht und mit einem Lift-off Verfahren strukturiert. Für vertikale Strukturen gibt es jedoch derzeit kein ausgereiftes Verfahren, mit dem ein Katalysatorsystem präzise an deren Boden positioniert werden kann, um anschließend in der vertikalen Struktur unter katalytischer Beschleunigung des Wachstums Nanoröhren, insbesondere einwandige ("Single Walled Carbon Nanotubes", SWCNTs) bzw. mehrwandige ("Multi Walled Carbon Nanotubes", MWCNTs) Kohlenstoffnanoröhren zu synthetisieren bzw. aufzuwachsen. Ein anderes Verfahren ist die elektrolytische Abscheidung eines entsprechenden Katalysatorsystems zur Beschleunigung des Wachstums von solchen Nanoröhren in vertikalen Strukturen. Hier lässt sich jedoch die Menge des abgeschiedenen Katalysatormetalls nur schwer kontrollieren. Außerdem ist eine elektrolytische Abscheidung von sehr geringen Mengen eines Katalysators, wie beispielsweise zur Synthese von SWCNTs notwendig, kaum möglich. Zudem läßt sich bei physikalischer Abscheidung des Katalysatorsystems in vorher definierte vertikale Strukturen eine Abscheidung an den Seitenwänden meistens nicht verhindern. Die Nanoröhren können daher auch von den Seitenwänden wachsen. In diesem Fall sind sie dann nicht mit dem Boden der vertikalen Struktur kontaktiert. Ein weiteres Verfahren besteht darin, die Katalysatorschicht vor der nichtleitenden Schicht aufzutragen und die vertikalen Strukturen nachträglich zu ätzen. Aufgrund von Prozeßschwankungen und Overetch gibt es jedoch bisher keine Lösung für einen präzisen Ätzstop auf eine Größenordnung von etwa 1 nm genau. Dies ist aber notwendig, um eine einzige Katalysatorschicht zum Aufwachsen der Nanoröhre freizulegen, ohne sie aber durchzuätzen.

Journal of Applied Physics, Vol. 91, No. 9, Seiten 6027-6033, beschreibt das Aufwachsen von Kohlenstoffnanoröhren auf einer Mo/Al/Fe-Schichtanordnung.

Es ist daher Aufgabe der vorliegenden Erfindung, die gezielte Erzeugung von Nanoröhren in vertikalen Strukturen elektronischer Strukturen bereitzustellen.
Diese Aufgabe wird durch die in den Ansprüchen gekennzeichneten Ausführungsformen gelöst.

Insbesondere wird ein integriertes elektronisches Bauelement gemäß Anspruch 1 bereitgestellt, umfassend ein Substrat, mindestens ein Metall-Mehrschichtsystem, das mindestens bereichsweise auf dem Substrat angeordnet ist, und eine auf dem Metall-Mehrschichtsystem angeordnete, nicht-leitende Schicht, die mindestens ein Kontaktloch aufweist, worin mindestens eine Nanoröhre am Boden des Kontaktlochs an dem Metall-Mehrschichtsystem aufgewachsen ist, wobei das Metall-Mehrschichtsystem aus einer hochschmelzenden Metallschicht, einer Metalltrennschicht und einer Katalysatorschicht aufgebaut ist.

Kern der Erfindung ist somit der Einsatz eines Metall-Mehrschichtsystems, das durch Kombination mehrerer spezifischer Metallschichten das Wachstum von Nanoröhren, d.h. SWCNTs bzw. MWCNTs, in vertikalen Strukturen auf insbesondere elektrisch leitfähigen Oberflächen (Metallen) ermöglicht.

Die hier beschriebene Erfindung löst das Problem, einen zum Aufwachsen von Nanoröhren geeigneten Katalysator definiert am Boden einer vertikalen Struktur anzuordnen, indem zuerst mindestens ein vorstehend definiertes Metall-Mehrschichtsystem auf ein entsprechendes Substrat abgeschieden wird. Dieses Metall-Mehrschichtsystem wird anschließend mit einer nichtleitenden Schicht abgedeckt. Die vertikalen Strukturen werden im folgenden üblicherweise durch Lithographie und Ätzprozesse in der nichtleitenden Schicht definiert, so daß das Metall-Mehrschichtsystem lokal am Boden der vertikalen Struktur freigelegt wird. Durch Einschließen des Katalysatormetalls in dem erfindungsgemäß verwendeten Mehrschichtsystem wird ein verbessertes Wachstum der Nanoröhren erreicht. Ferner kann das Problem, bei einem Ätzprozeß Nanometer genau auf einer Katalysatorschicht zu stoppen, durch mehrfache Abscheidung einer Abfolge von Katalysator- und Trennschichten gelöst werden. Es reicht hiernach, wenn auf einer der Katalysatorschichten gestoppt wird, bzw. die Katalysatorschicht(en) nach dem Ätzprozeß am Rand der vertikalen Struktur freigelegt wird bzw. werden.

Das erfindungsgemäß verwendete Metall-Mehrschichtsystem zum Aufwachsen von Nanoröhren umfaßt eine hochschmelzende Metallschicht, die als Bodenkontaktschicht fungiert, eine Metallschicht, die den Katalysator von der darunterliegenden Bodenkontaktschicht separiert, und die eigentliche Katalysatorschicht. Durch mehrfach aufeinanderfolgende Abscheidung der Sequenz hochschmelzende Metallschicht/Metalltrennschicht/Katalysatorschicht lässt sich die Ausbeute an Nanoröhren, insbesondere SWCNTs bzw. MWCNTs, erhöhen. Außerdem erleichtert dies den Ätzprozeß, da, wie bereits vorstehend ausgeführt, nicht auf einer bestimmten Katalysatorschicht, sondern auf einer der Katalysatorschichten des Mehrschichtsystems gestoppt werden braucht, nachdem zur Erzeugung der vertikalen Strukturen auf das Metall-Mehrschichtsystem eine nicht-leitende Schicht abgeschieden worden ist, die anschließend durch Lithographie und Ätzprozesse strukturiert wird.

Für die hochschmelzende Metallschicht haben sich Tantal, Molybdän und Wolfram bzw. Silicium als günstig erwiesen. Die Metalltrennschicht umfasst Aluminium, Gold oder Silber, vorzugsweise Aluminium. Die Metalltrennschicht, die zwischen hochschmelzender Metallschicht und Katalysatorschicht angeordnet ist, wirkt sich sehr günstig auf das Wachstum der Nanoröhren, d.h. SWCNTs bzw. MWCNTs, aus. Man nimmt an, daß das Metall der Metalltrennschicht während des Verfahrens schmilzt und beispielsweise das ebenfalls geschmolzene Katalysatormaterial, wie z.B. Eisen, in der flüssigen Phase aus beispielsweise Aluminium eingebettet ist und somit seinen "Inselcharakter" beibehält, von dem das Wachstum der Nanoröhren und die Art der Röhren (SWCNTs oder MWCNTs) abhängt. Ohne Trennschicht besteht daüberhinaus die Gefahr, daß das Katalysatormaterial in die angrenzenden Schichten diffundiert. Die Katalysatorschicht umfasst eines bzw. eine Kombination der folgenden Metalle: Eisen, Kobalt, Nickel, Yttrium, Titan, Platin und Palladium. Übliche Materialien für die nicht-leitende Schicht sind zum Beispiel SiO₂, SiₓN_{y}, Al₂O₃, ZrO₂ und HfO₂.

Erfindungsgemäß weist das Metall-Mehrschichtsystem zusätzlich eine, über der Katalysatorschicht angeordnete, abschließende Metalltrennschicht aus Aluminium, Gold oder Silber auf.

In dem Bauelement gemäß der vorliegenden Erfindung kann das Metall-Mehrschichtsystem auf einer ersten leitenden Schicht als dem Substrat angeordnet sein. Darüberhinaus kann eine zweite leitende Schicht dergestalt angeordnet sein, daß sie über die mindestens eine Nanoröhre in dem Kontaktloch mit der ersten leitenden Schicht elektrisch leitend verbunden ist. Die erste und die zweite leitende Schicht können dabei beispielsweise Kupfer und/oder Aluminium und/oder eine Kombination von Ta, TaN, Ti und TiN umfassen.

Ein weiterer Gegenstand der vorliegenden Erfindung betrifft ein Verfahren zur gezielten Erzeugung von einwandigen Kohlenstoffnanoröhren (SWCNTs) und mehrwandigen Kohlenstoffnanoröhren (MWCNTs), in vertikalen Strukturen, insbesondere auf elektrisch leitfähigen Oberflächen gemäß Anspruch 6, umfassend die Schritte,
(i) Bereitstellen eines Substrats (10),
(ii) aufeinanderfolgendes Abscheiden einer hochschmelzenden Metallschicht (20), einer Metalltrennschicht (30) und einer Katalysatorschicht (40) unter Ausbildung eines Metall-Mehrschichtsystems mindestens bereichsweise auf dem Substrat (10), wobei die hochschmelzende Metallschicht (20) aus einem Metall, ausgewählt aus der Gruppe, bestehend aus Tantal, Molybdän und Wolfram, aufgebaut ist,
   wobei die Metalltrennschicht (30) aus Aluminium, Gold oder Silber aufgebaut ist, und
   wobei die Katalysatorschicht (40) aus einem Metall, ausgewählt aus der Gruppe, bestehend aus Eisen, Kobalt, Nickel, Yttrium, Titan, Platin und Palladium und einer Kombination davon, aufgebaut ist,
(iii) gegebenenfalls ein- oder mehrfaches Wiederholen des Schrittes (ii), wobei auf das in Schritt (ii) bzw. (iii) erzeugte Metall-Mehrschichtsystem über die Katalysatorschicht (40) eine abschließende Metalltrennschicht (60) aus Aluminium, Gold oder Silber abgeschieden wird,
(iv) Abscheiden einer nicht-leitenden Schicht (50) über das derart erzeugte Metall-Mehrschichtsystem,
(v) Erzeugen mindestens eines Kontaktlochs (80) in der nicht-leitenden Schicht (50), so dass sich das Metall-Mehrschichtsystem mindestens bereichsweise über den Boden des erzeugten Kontaktlochs (80) erstreckt, und
(vi) Aufwachsen mindestens einer Kohlenstoffnanoröhre (90) auf dem Metall-Mehrschichtsystem in dem Kontaktloch (80).

In dem erfindungsgemäßen Verfahren kann das Substrat eine erste leitende Schicht sein und nach Schritt (vi) kann eine zweite leitende Schicht derart abgeschieden werden, daß die erste leitende Schicht durch die mindestens eine Nanoröhre mit der zweiten leitenden Schicht elektrisch leitend verbunden wird.

Die Bildung der einwandigen Kohlenstoffnanoröhre(n) (SWCNTs) und/oder der mehrwandigen Kohlenstoffnanoröhre(n) (MWCNTs) in dem Kontaktloch in Schritt (vi) kann mittels CVD-Verfahren erfolgen. Das mindestens eine Kontaktloch kann in Schritt (v) beispielsweise mittels lithographischem Trockenätzen erzeugt werden. Die Bildung des Metall-Mehrschichtsystems in Schritt (ii) kann mittels CVD-Verfahren, Sputtern oder Aufdampf-Verfahren erfolgen.

Im Rahmen der vorliegenden Erfindung wird die Verwendung eines Metall-Mehrschichtsystems, aufgebaut aus einer hochschmelzenden Metallschicht, einer Metalltrennschicht und einer Katalysatorschicht, zur gezielten Herstellung von Nanoröhren, insbesondere einwandigen Kohlenstoffnanoröhren (SWCNTs) und mehrwandigen Kohlenstoffnanoröhren (MWCNTs), in vertikalen Strukturen auf elektrisch leitfähigen Oberflächen, insbesondere als Vias zur Verbindung unterschiedlicher Metallisierungsebenen oder im Falle von einwandigen halbleitenden Kohlenstoffnanoröhren als schaltendes Transistorelement vorgesehen.

Das erfindungsgemäße Verfahren ermöglicht es, selbst bei Kontaktlöchern mit sehr geringem Durchmesser und großem Aspektverhältnis eine zuverlässige elektrisch leitende Verbindung zwischen zwei leitenden Schichten zu erzeugen, die durch eine nicht-leitende Schicht an sich elektrisch entkoppelt sind. Diese vorliegende Erfindung eignet sich somit zum gezielten Wachstum von einwandigen und mehrwandigen Kohlenstoffnanoröhren als Vias, d.h. zur Verbindung von Leitbahnen unterschiedlicher Metallisierungsebenen. Die leitenden Schichten können beispielsweise jedes metallisch leitende Material sein, wie z.B. Kupfer, Aluminium, Silber, etc., wobei die leitfähigen Schichten üblicherweise eine Haft-, Diffusions- und Antireflexionsschicht, beispielsweise Ti, TiN, Ta, TaN und/oder eine Kombination dieser Materialien, aufweisen können. Die elektrisch nicht-leitende Schicht kann ein herkömmliches Dielektrikum wie beispielsweise Siliciumdioxid oder Siliciumnitrid oder eine andere isolierende Schicht aus organischem Material wie beispielsweise Polyimid oder eine beliebige Kombination davon sein. Die elektrisch leitende Verbindung mittels mindestens einer Nanoröhre ist lediglich durch den Durchmesser einer solchen Nanoröhre, die bei einer Kohlenstoffnanoröhre bei ungefähr 0,4 bis 0,7 nm Durchmesser liegt, begrenzt.

Darüberhinaus wird durch die vorliegende Erfindung die Verwirklichung eines vertikalen Kohlenstoffnanoröhrentransistors ermöglicht, wenn das Gate in die nicht-leitende Schicht integriert wird.

Das erfindungsgemäße Verfahren zeichnet sich durch seine Einfachheit und Robustheit, d.h. durch eine geringe Fehleranfälligkeit, und dadurch aus, daß zuverlässig eine elektrisch leitende Verbindung hergestellt wird. Somit sind entsprechende elektrische Bauelemente selbst bei sehr feinen Strukturen, d.h. bei geringem Durchmesser eines Kontaktlochs, einfach und kostengünstig herstellbar.

Die Figuren zeigen:
Figur 1 zeigt schematisch die Anordnung von Substrat, Metall-Mehrschichtsystem und nicht-leitender Schicht.
Figur 2a zeigt schematisch eine Ausführungsform gemäß der vorliegenden Erfindung, worin eine zusätzlich über der Katalysatorschicht angeordnete, abschließende Metalltrennschicht vorgesehen ist.
Figur 2b zeigt schematisch eine weitere Ausführungsform gemäß der vorliegenden Erfindung, worin das Metall-Mehrschichtsystem mehrfach übereinander angeordnet ist.
Figur 3a zeigt schematisch ein durch Lithographie- und Ätzprozesse vorstrukturiertes Element, worin bereichsweise das Metall-Mehrschichtsystem freigelegt ist.
Figur 3b zeigt schematisch das in Figur 3a gezeigte vorstrukturierte Element nach dem Aufwachsen der Nanoröhren.
Figuren 4a und 4b zeigen Rasterelektronenmikroskopieaufnahmen von auf den erfindungsgemäß verwendeten Metall-Mehrschichtsystemen gewachsenen MWCNTs.
Figur 5 zeigt eine Rasterelektronenmikroskopieaufnahme von auf den erfindungsgemäß verwendeten Metall-Mehrschichtsystemen gewachsenen SWCNTs.

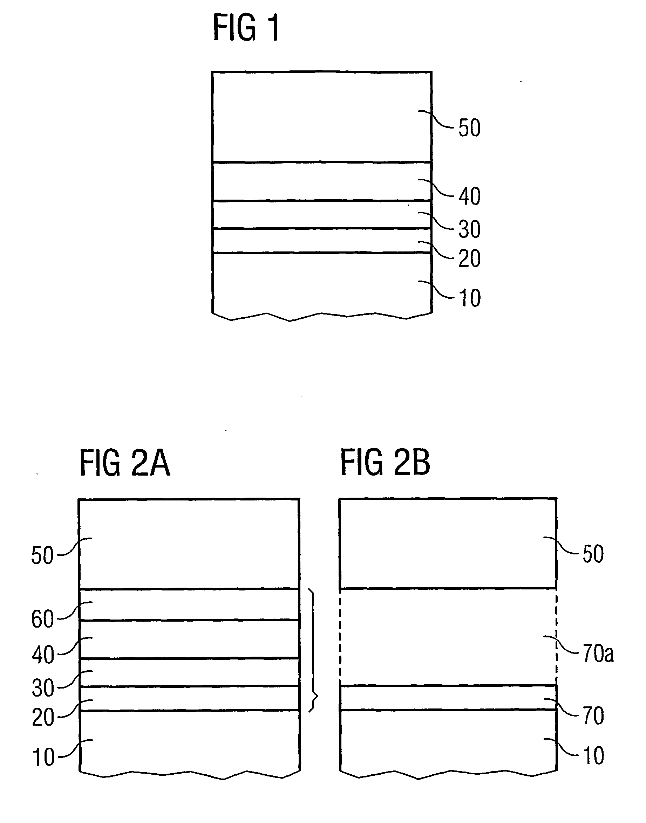

Figur 1 zeigt ein Substrat 10, auf dem ein Metall-Mehrschichtsystem angeordnet ist, wobei das Metall-Mehrschichtsystem aus einer hochschmelzenden Metallschicht 20, einer Metalltrennschicht 30 und einer Katalysatorschicht 40 aufgebaut ist. Auf dem Metall-Mehrschichtsystem, genauer auf der Katalysatorschicht 40 ist eine nicht-leitende Schicht 50 angeordnet.

Das Substrat 10 kann beispielsweise eine leitende Schicht aus jedwedem leitenden Material, z.B. Kupfer, Aluminium, Silber, etc. sein. Für die hochschmelzende Metallschicht 20 werden Tantal, Molybdän, Wolfram und/oder Silicium eingesetzt. Die zwischen hochschmelzender Metallschicht 20 und Katalysatorschicht 40 angeordnete Metalltrennschicht 30 wirkt sich günstig auf das Wachstum der SWCNTs bzw. MWCNTs, aus. Ohne Metalltrennschicht 30 besteht zudem die Gefahr, daß der Katalysator aus der Katalysatorschicht 40 in die angrenzenden Schichten diffundiert. Die Metalltrennschicht 30 umfasst Aluminium, Gold oder Silber und ist vorzugsweise aus Aluminium aufgebaut. Die Katalysatorschicht 40 umfasst eines oder mehrere der folgenden Metalle: Eisen, Kobalt, Nickel, Yttrium, Titan, Platin und Palladium. Beispielhafte Materialien für die nicht-leitende Schicht 50 sind SiO₂, SiₓN_{y}, Al₂O₃, ZrO₂ und HfO₂.

Die Bildung des in Figur 1 dargestellten Metall-Mehrschichtsystems kann mittels CVD-Verfahren, Sputtern oder Aufdampf-Verfahren erfolgen.

Figur 2a zeigt schematisch die Abfolge der einzelnen Schichten wie in Figur 1, wobei auf der Katalysatorschicht 40 eine zusätzliche abschließende Metalltrennschicht 60 angeordnet ist. Diese umfaßt vorzugsweise wiederum Aluminium.

Figur 2b zeigt im wesentlichen den gleichen Aufbau wie in Figur 2a, wobei das die hochschmelzender Metallschicht 20, die Metalltrennschicht 30, die Katalysatorschicht 40 und die zusätzliche abschließende Metalltrennschicht 60 umfassende Metall-Mehrschichtsystem 70 mehrfach übereinander angeordnet ist (70a).

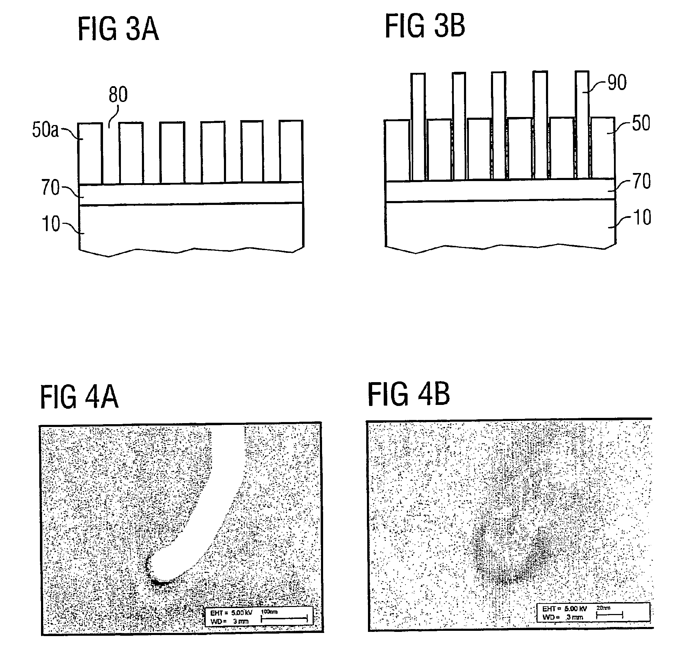

Figur 3a zeigt schematisch die Anordnung von Substrat 10, Metall-Mehrschichtsystem 70 und einer vorstrukturierten nicht-leitenden Schicht 50a. Die vorliegenden vertikalen Strukturen (Kontaktlöcher 80) können durch Lithographie und Ätzprozesse in der nichtleitenden Schicht 50 definiert werden.

Figur 3b zeigt auf dem Metall-Mehrschichtsystem 70 in den vertikalen Strukturen der vorstrukturierten nicht-leitenden Schicht 50a aufgewachsene Nanoröhren 90. Die Bildung der Nanoröhren 90, d.h. einwandiger Kohlenstoffnanoröhren (SWCNTs) und/oder mehrwandiger Kohlenstoffnanoröhren (MWCNTs), in den Kontaktlöchern 80 kann mittels CVD-Verfahren erfolgen. Durch den erfindungsgemäßen Aufbau wachsen die Nanoröhren 90 selektiv auf dem Metall-Mehrschichtsystem 70 in den Kontaktlöchern 80, wobei ein unerwünschtes Wachstum von den Seitenwänden vermieden wird.

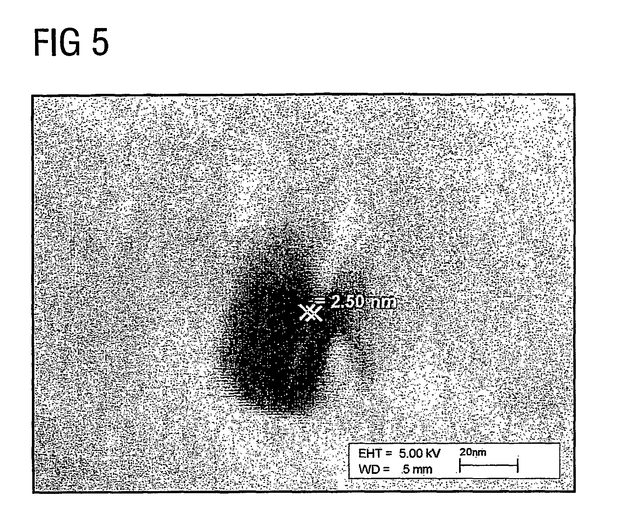

Figuren 4a, 4b und 5 zeigen Rasterelektronenmikroskopieaufnahmen von MWCNTs (Figuren 4a und 4b) und SWCNTs (Figur 5). Die erfindungsgemäße Erzeugung von Nanoröhren in vertikalen Strukturen resultiert nicht nur in der gezielten Darstellung von MWCNTs (Figuren 4a und 4b) und SWCNTs (Figur 5), sondern auch in einer gezielten Vermeidung des Wachstums der Nanoröhren von den Seitenwänden, was aus den Figuren 4a bis 5 ersichtlich ist.

### Bezugszeichenliste

- 10: Substrat
- 20: hochschmelzende Metallschicht
- 30: Metalltrennschicht
- 40: Katalysatorschicht
- 50: nicht-leitende Schicht
- 50a: vorstrukturierte nicht-leitende Schicht
- 60: zusätzliche abschließende Metalltrennschicht
- 70: Metall-Mehrschichtsystem
- 70a: mehrfache Wiederholung des Metall-Mehrschichtsystems
- 80: Kontaktloch
- 90: Nanoröhre(n)

## Patentansprüche

1. Integriertes elektronisches Bauelement, umfassend ein Substrat (10),
mindestens ein Metall-Mehrschichtsystem (70), das mindestens bereichsweise auf dem Substrat (10) angeordnet ist, wobei das Metall-Mehrschichtsystem aus einer hochschmelzenden Metallschicht (20), einer Metalltrennschicht (30)und einer Katalysatorschicht (40) in dieser Reihenfolge auf dem Substrat aufgebaut ist,
wobei die hochschmelzende Metallschicht (20) aus einem Metall, ausgewählt aus der Gruppe, bestehend aus Tantal, Molybdän und Wolfram, aufgebaut ist,
wobei die Metalltrennschicht (30) aus Aluminium, Gold oder Silber aufgebaut ist, und
wobei die Katalysatorschicht (40) aus einem Metall, ausgewählt aus der Gruppe, bestehend aus Eisen, Kobalt, Nickel, Yttrium, Titan, Platin und Palladium und einer Kombination davon, aufgebaut ist,
und
eine auf dem mindestens einen Metall-Mehrschichtsystem über der Katalysatorschicht (40) angeordnete, abschließende Metalltrennschicht (60) aus Aluminium, Gold oder Silber,
und eine auf dem Metall-Mehrschichtsystem angeordnete, nicht-leitende Schicht (50), die mindestens ein Kontaktloch (80) aufweist, worin mindestens eine einwandige Kohlenstoffnanoröhre (SWCNT) oder eine mehrwandige Kohlenstoffnanoröhre (MWCNT) (90) am Boden des Kontaktlochs (80) an dem Metall-Mehrschichtsystem aufgewachsen ist,

2. Bauelement nach Anspruch 1, wobei die nicht-leitende Schicht (50) aus SiO₂, SiₓN_{y}, Al₂O₃, ZrO₂ oder HfO₂ oder einer Kombination davon aufgebaut ist.

3. Bauelement nach Anspruch 1 oder 2, wobei das Metall-Mehrschichtsystem auf einer ersten leitenden Schicht als dem Substrat (10) angeordnet ist.

4. Bauelement nach Anspruch 3, welches weiter eine zweite leitende Schicht dergestalt aufweist, dass über die mindestens eine Kohlenstoffnanoröhre (90) in dem Kontaktloch (80) die erste leitende Schicht mit der zweiten leitenden Schicht elektrisch leitend verbunden ist.

5. Bauelement nach Anspruch 4, wobei die erste und die zweite leitende Schicht Kupfer und/oder Aluminium und eine Kombination von Ta, TaN, Ti, TiN umfassen.

6. Verfahren zur gezielten Erzeugung von einwandigen Kohlenstoffnanoröhren (SWCNT) oder mehrwandigen Kohlenstoffnanoröhren (MWCNT) in vertikalen Strukturen, umfassend die Schritte,
(i) Bereitstellen eines Substrats (10),
(ii) aufeinanderfolgendes Abscheiden einer hochschmelzenden Metallschicht (20), einer Metalltrennschicht (30) und einer Katalysatorschicht (40) unter Ausbildung eines Metall-Mehrschichtsystems mindestens bereichsweise auf dem Substrat (10), wobei die hochschmelzende Metallschicht (20) aus einem Metall, ausgewählt aus der Gruppe, bestehend aus Tantal, Molybdän und Wolfram, aufgebaut ist,
wobei die Metalltrennschicht (30) aus Aluminium, Gold oder Silber aufgebaut ist, und
wobei die Katalysatorschicht (40) aus einem Metall, ausgewählt aus der Gruppe, bestehend aus Eisen, Kobalt, Nickel, Yttrium, Titan, Platin und Palladium und einer Kombination davon, aufgebaut ist,
(iii) gegebenenfalls ein- oder mehrfaches Wiederholen des Schrittes (ii),
wobei auf das in Schritt (ii) bzw. (iii) erzeugte Metall-Mehrschichtsystem über die Katalysatorschicht (40) eine abschließende Metalltrennschicht (60) aus Aluminium, Gold oder Silber abgeschieden wird,
(iv) Abscheiden einer nicht-leitenden Schicht (50) über das derart erzeugte Metall-Mehrschichtsystem,
(v) Erzeugen mindestens eines Kontaktlochs (80) in der nichtleitenden Schicht (50), so dass sich das Metall-Mehrschichtsystem mindestens bereichsweise über den Boden des erzeugten Kontaktlochs (80) erstreckt, und
(vi) Aufwachsen mindestens einer Kohlenstoffnanoröhre (90) auf dem Metall-Mehrschichtsystem in dem Kontaktloch (80).

7. Verfahren nach Anspruch 6, wobei das Substrat (10) eine erste leitende Schicht ist und nach Schritt (vi) eine zweite leitende Schicht derart abgeschieden wird, dass die erste leitende Schicht durch die mindestens eine Nanoröhre (90) mit der zweiten leitenden Schicht elektrisch leitend verbunden ist.

8. Verfahren nach Anspruch 6 oder 7, wobei in Schritt (vi) einwandige Kohlenstoffnanoröhren (SWCNTs) und/oder mehrwandige Kohlenstoffnanoröhren (MWCNTs) mittels CVD-Verfahren in dem Kontaktloch (80) aufgewachsen werden.

9. Verfahren nach einem der Ansprüche 6 bis 8, worin in Schritt (v) das mindestens eine Kontaktloch (80) mittels lithographischen Trockenätzens erzeugt wird.

10. Verfahren nach einem der Ansprüche 6 bis 9, worin in Schritt (ii) das Ausbilden des Metall-Mehrschichtsystems mittels CVD-Verfahren, Sputtern oder Aufdampf-Verfahren erfolgt.

## Claims

1. An integrated electronic component, comprising a substrate (10),
at least one metal multilayer system, which is arranged at least on regions of the substrate (10), the metal multilayer system being composed of a high-melting metal layer (20), a metal separating layer (30) and a catalyst layer (40) in this series on the substrate,
in which the high-melting metal layer (20) is composed of a metal selected from the group consisting tantalum, molybdenum and tungsten,
in which the metal separating layer (30) is composed of aluminum, gold or silver, and
in which the catalyst layer (40) is composed of a metal selected from the group consisting of iron, cobalt, nickel, yttrium, titanium, platinum and palladium and a combination thereof, and
a final metal separating layer (60) of aluminum, gold or silver arranged above the catalyst layer (40) on the at least one metal multilayer system, and
a non-conductive layer (50), which is arranged on the metal multilayer system and has at least one contact hole (80), in which at least one single-walled carbon nanotube (SWCNT) or multi-walled carbon nanotube (MWCTNs) (90) is grown on the metal multilayer system at the bottom of the contact hole (80).

2. The component as claimed in claim 1, in which the non-conductive layer (50) is composed of SiO₂, SiₓN_{y}, Al₂O₃, ZrO₂ or HfO₂ or a combination thereof.

3. The component as claimed in claims 1 or 2, in which the metal multilayer system is arranged on a first conductive layer as the substrate (10).

4. The component as claimed in claim 3, which further includes a second conductive layer, in such a form that the first conductive layer is electrically conductively connected to the second conductive layer via the at least one nanotube (90) in the contact hole (80).

5. The component as claimed in claim 4, in which the first and second conductive layers comprise copper and/or aluminum and a combination of Ta, TaN, Ti, TiN.

6. A process for the targeted production of single-walled carbon nanotubes (SWCNTs) or multi-walled carbon nanotubes (MWCTNs), in vertical structures, comprising the steps of :
(i) providing a substrate (10),
(ii) successively depositing a high-melting metal layer (20), a metal separating layer (30) and a catalyst layer (40), so as to form a metal multilayer system at least on regions of the substrate (10), in which the high-melting metal layer (20) is composed of a metal selected from the group consisting tantalum, molybdenum and tungsten, in which the metal separating layer (30) is composed of aluminum, gold or silver, and in which the catalyst layer (40) is composed of a metal selected from the group consisting of iron, cobalt, nickel, yttrium, titanium, platinum and palladium and a combination thereof,
(iii) optionally, repeating step (ii) one or more times,
wherein a final metal separating layer (60) of aluminum, gold or silver is deposited over the catalyst layer (40) on the metal multilayer system produced in step (ii) and/or (iii),
(iv) depositing a non-conductive layer (50) over the thus produced metal multilayer system,
(v) producing at least one contact hole (80) in the non-conductive layer (50), so that the metal multilayer system extends over the base of the contact hole (80) produced at least in regions, and
(vi) growing at least one nanotube (90) on the metal multilayer system in the contact hole (80).

7. The process as claimed in claim 6, in which the substrate (10) is a first conductive layer, and a second conductive layer is deposited after step (vi), in such a manner that the first conductive layer is electrically conductively connected to the second conductive layer by the at least one nanotube (90).

8. The process as claimed in claim 6 or 7, in which in step (vi) single-walled carbon nanotubes (SWCNTs) and/or multi-walled carbon nanotubes (MWCNTs) are grown in the contact hole (80) by means of CVD processes.

9. The process as claimed in one of claims 6 to 8, in which in step (v) the at least one contact hole (80) is produced by means of lithographic dry etching.

10. The process as claimed in one of claims 6 to 9, in which in step (ii) the metal multilayer system is formed by means of CVD processes, sputtering or evaporation coating processes.

## Revendications

1. Composant électronique intégré comprenant un substrat (10),
au moins un système multicouche en métal (70) qui est disposé au moins par zones sur le substrat (10), le système multicouche en métal étant formé sur le substrat à partir d'une couche en métal à point de fusion élevé (20), d'une couche de séparation en métal (30) et d'une couche de catalyseur (40), dans cet ordre,
la couche en métal à point de fusion élevé (20) étant formée à partir d'un métal choisi dans le groupe constitué par le tantale, le molybdène et le tungstène,
la couche de séparation en métal (30) étant formée à partir d'aluminium, d'or ou d'argent, et
la couche de catalyseur (40) étant formée à partir d'un métal choisi dans le groupe constitué par le fer, le cobalt, le nickel, l'yttrium, le titane, le platine et le palladium, ou d'une combinaison de ceux-ci, et
une couche de séparation en métal terminale (60) en aluminium, en or ou en argent qui est disposée sur le ou les systèmes multicouches en métal, au-dessus de la couche de catalyseur (40),
et une couche non conductrice (50), disposée sur le système multicouche en métal, qui présente au moins un trou de contact (80), au moins un nanotube de carbone à paroi simple (SWCNT) ou un nanotube de carbone à paroi multiple (MWCNT) (90) croissant sur le fond du trou de contact (80) sur le système multicouche en métal.

2. Composant selon la revendication 1, dans lequel la couche non conductrice (50) est formée à partir de SiO₂, SiₓN_{y}, Al₂O₃, ZrO₂ ou HfO₂ ou d'une combinaison de ceux-ci.

3. Composant selon la revendication 1 ou 2, dans lequel le système multicouche en métal est disposé sur une première couche conductrice comme substrat (10).

4. Composant selon la revendication 3, qui comporte également une seconde couche conductrice, de telle sorte que par l'intermédiaire du ou des nanotubes de carbone (90) placés dans le trou de contact (80), la première couche conductrice soit reliée à la seconde en étant conductrice d'électricité.

5. Composant selon la revendication 4, dans lequel les première et seconde couches conductrices comprennent du cuivre et/ou de l'aluminium et une combinaison de Ta, TaN, Ti, TiN.

6. Procédé pour la production ciblée de nanotubes de carbone à paroi simple (SWCNT) ou de nanotubes de carbone à paroi multiple (MWCNT) dans des structures verticales, comprenant les étapes qui consistent
(i) à préparer un substrat (10),
(ii) à déposer successivement sur le substrat (10), au moins par zones, une couche en métal à point de fusion élevé (20), une couche de séparation en métal (30) et une couche de catalyseur (40) en formant un système multicouche en métal, la couche en métal à point de fusion élevé (20) étant formée à partir d'un métal choisi dans le groupe constitué par le tantale, le molybdène et le tungstène,
la couche de séparation en métal (30) étant formée à partir d'aluminium, d'or ou d'argent, et
la couche de catalyseur (40) étant formée à partir d'un métal choisi dans le groupe constitué par le fer, le cobalt, le nickel, l'yttrium, le titane, le platine et le palladium, ou d'une combinaison de ceux-ci,
(iii) à répéter éventuellement une ou plusieurs fois l'étape (ii),
une couche de séparation en métal terminale (60) en aluminium, en or ou en argent étant déposée sur le système multicouche en métal produit lors des étapes (ii) et (iii), au-dessus de la couche de catalyseur (40),
(iv) à déposer une couche non conductrice (50) sur le système multicouche en métal ainsi produit,
(v) à produire au moins un trou de contact (80) dans la couche non conductrice (50), de sorte que le système multicouche en métal s'étend au moins par zones sur le fond du trou de contact (80) produit, et
(vi) à faire croître au moins un nanotube de carbone (90) sur le système multicouche en métal, dans le trou de contact (80).

7. Procédé selon la revendication 6, selon lequel le substrat (10) consiste en une première couche conductrice, et après l'étape (vi) on dépose une seconde couche conductrice de telle sorte que la première soit reliée à la seconde en étant conductrice d'électricité, par l'intermédiaire du ou des nanotubes (90).

8. Procédé selon la revendication 6 ou 7, selon lequel lors de l'étape (vi) on fait croître dans le trou de contact (80) des nanotubes de carbone à paroi simple (SWCNT) et/ou des nanotubes de carbone à parois multiples (MWCNT) à l'aide d'un procédé de dépôt chimique en phase vapeur.

9. Procédé selon l'une des revendications 6 à 8, selon lequel lors de l'étape (v) le ou les trous de contact (80) sont produits par gravure sèche lithographique.

10. Procédé selon l'une des revendications 6 à 9, selon lequel lors de l'étape (ii), la formation du système multicouche en métal se fait à l'aide d'un procédé de dépôt chimique en phase vapeur, de pulvérisation cathodique ou d'un procédé de vaporisation.
